# EUROPEAN PATENT APPLICATION

(11) **EP 4 669 045 A1**
(43) Date of publication of application: **24.12.2025**
(21) Application number: 24778036.4
(22) Date of filing: 27.03.2024
(51) Int. Cl.: H05K 7/20

(54) **HEAT SINK AND ELECTRONIC DEVICE ASSEMBLY**

(30) Priority: 27.03.2023 CN 202310312076
(71) Applicant: ZTE CORPORATION, Shenzhen, Guangdong 518057 (CN)
(72) Inventor: CHEN, Xiaoxue, Shenzhen, Guangdong 518057 (CN); DUAN, Kaiwen, Shenzhen, Guangdong 518057 (CN); WANG, Yan, Shenzhen, Guangdong 518057 (CN); LIU, Xin, Shenzhen, Guangdong 518057 (CN); NIE, Zhidong, Shenzhen, Guangdong 518057 (CN)
(74) Representative: Canzler & Bergmeier Patentanwälte Partnerschaft mbB
(86) International application number: PCT/CN2024/083952
(87) International publication number: WO 2024/199248

(57) **Abstract**

The present disclosure provides a heat sink, comprising a heat-conducting base and cooling fin sets connected to one side of the heat-conducting base. Each cooling fin set comprises a plurality of main cooling fins arranged at intervals in a first direction, each main cooling fin is arranged inclinedly relative to a second direction, and the inclination directions of any two adjacent main cooling fins relative to the second direction are opposite; the first direction and the second direction are perpendicular to each other. The present disclosure further provides an electronic device assembly.

## Description

### CROSS REFERENCE TO RELATED APPLICATIONS

The present disclosure claims the priority to Chinese Patent Application No. 202310312076.7 filed on March 27, 2023, the contents of which are incorporated herein by reference in their entirety.

### TECHNICAL FIELD

The present disclosure relates to the technical field of heat dissipation, and in particular, to a heat sink and an electronic device assembly.

### BACKGROUND

With the development of 5th Generation Mobile Communication (5G) technology, communication devices (such as an Active Antenna Unit (AAU) and a Remote Radio Unit (RRU)) are continuously developing towards integration, high power, and large capacity. As a resuly, a large amount of heat is generated during the operation of the communication devices, which puts high pressure on heat dissipation and can easily cause the problem of hot cascade.

### SUMMARY

The present disclosure provides a heat sink and an electronic device assembly.

In a first aspect, the embodiments of the present disclosure provide a heat sink, including a heat conducting substrate and a radiating fin group connected to a side of the heat conducting substrate, wherein the radiating fin group includes a plurality of main radiating fins arranged at intervals along a first direction, one of main radiating fins is inclined with respect to a second direction, and inclination directions of any two adjacent main radiating fins with respect to the second direction are opposite; and the first direction and the second direction are perpendicular to each other.

In a second aspect, the embodiments of the present disclosure provide an electronic device assembly, including an electronic device and the heat sink according to any one of the embodiments of the present disclosure, wherein a heat conduction passage is formed between the electronic device and a side of the heat conducting substrate away from the radiating fin group; and the second direction is the direction of gravity in the case where the electronic device is arranged in a predetermined arrangement manner.

In the heat sink according to the embodiments of the present disclosure, the main radiating fins are inclined with respect to the direction of gravity (i.e., the second direction), and the inclination directions of the adjacent main radiating fins are opposite. This arrangement forms the passages with gradually changing widths between the adjacent main radiating fins. A gas in first-type passages with "narrow tops and wide bottoms" can be automatically accelerated due to the narrowing of the flow passages while being heated to rise. As a result, for different positions at the heat sink, the upper the position, the faster the gas flows and the better the heat dissipation capacity. Thus, the heat sink according to the embodiments of the present disclosure can produce a good heat dissipation effect and eliminate the problem of hot cascade, or can realize light weight and miniaturization while maintaining the same heat dissipation effect. Meanwhile, in the heat sink according to the embodiments of the present disclosure, the gas mainly flows in from the bottom of the heat sink and then flows out from the top of the heat sink, so that the heat dissipation effect of the heat sink is not affected when the electronic device has a large width or adopts a flag-like manner, and thus is applicable to various situations.

### BRIEF DESCRIPTION OF DRAWINGS

In the drawings in connection with the embodiments of the present disclosure:
FIG. 1 is a side view of a heat sink adopting straight teeth in some related arts;
FIG. 2 is a side view of a heat sink adopting V-shaped teeth in some related arts;
FIG. 3 is a schematic structural diagram of a heat sink according to an embodiment of the present disclosure;
FIG. 4 is a side view of the heat sink shown in FIG. 3;
FIG. 5 is a schematic diagram illustrating a positional relationship between main radiating fins in a part of the heat sink shown in FIG. 3;
FIG. 6 is a side view of another heat sink according to an embodiment of the present disclosure;
FIG. 7 is a side view of another heat sink according to an embodiment of the present disclosure;
FIG. 8 is a side view of another heat sink according to an embodiment of the present disclosure;
FIG. 9 is a side view of another heat sink according to an embodiment of the present disclosure;
FIG. 10 is a schematic structural diagram of a cover plate used in another heat sink according to an embodiment of the present disclosure;
FIG. 11 is an exploded view of another heat sink according to an embodiment of the present disclosure;
FIG. 12 is a partial sectional view of the heat sink shown in FIG. 11;
FIG. 13 shows airflow velocity cloud maps of a heat sink in the related technology and a heat sink according to the embodiments of the present disclosure; and
FIG. 14 is a schematic structural diagram of an electronic device assembly according to an embodiment of the present disclosure.

### DETAIL DESCRIPTION OF EMBODIMENTS

In order to enable those of ordinary skill in the art to better understand the technical solutions of the present disclosure, a heat sink and an electronic device assembly provided in the embodiments of the present disclosure are described in detail below with reference to the drawings.

The present disclosure will be described more fully below with reference to the drawings, but the embodiments illustrated may be embodied in different forms, and the present disclosure should not be interpreted as being limited to the embodiments described below. Rather, the embodiments are provided to make the present disclosure thorough and complete, and are intended to enable those of ordinary skill in the art to fully understand the scope of the present disclosure.

The drawings for the embodiments of the present disclosure are intended to provide a further understanding of the embodiments of the present disclosure and constitute a part of the specification. Together with the specific embodiments of the present disclosure, the drawings are used to explain the present disclosure, but do not constitute any limitation to the present disclosure. The above and other features and advantages will become more apparent to those of ordinary skill in the art from the description of the specific embodiments with reference to the drawings.

The present disclosure can be described with reference to plans and/or cross-sectional views and/or three-dimensional diagrams with the aid of idealized schematic diagrams of the present disclosure. Accordingly, the exemplary drawings may be modified according to manufacturing techniques and/or tolerances.

All the embodiments of the present disclosure and the features therein may be combined with each other if no conflict is incurred.

The terms used herein are merely used to describe the specific embodiments, and are not intended to limit the present disclosure. The term "and/or" used herein includes any and all combinations of one or more associated listed items. The terms "one" and "the" used herein which indicate a singular form are intended to include a plural form, unless expressly stated in the context. The terms "include" and "be made of" used herein indicate the presence of the described features, integers, operations, elements and/or components, but do not exclude the presence or addition of one or more other features, integers, operations, elements, components and/or combinations thereof.

Unless otherwise defined, all terms (including technical and scientific terms) used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein. For example, unless defined otherwise, the term "connect" used herein should be understood broadly, for example, the term "connect" may refer to fixed connection, or detachable connection, or one-piece connection (integrated formation integrally).

The present disclosure is not limited to the embodiments illustrated by the drawings, but includes modifications to configuration formed based on a manufacturing process. Thus, regions shown in the drawings are illustrative, and shapes of the regions shown in the drawings illustrate specific shapes of regions of elements, but are not intended to make limitations.

With the development of 5G technology, communication devices (such as an AAU and an RRU) are continuously developing towards integration, high power, and large capacity. As a result, a large amount of heat is generated during the operation of the communication devices, which puts high pressure on heat dissipation.

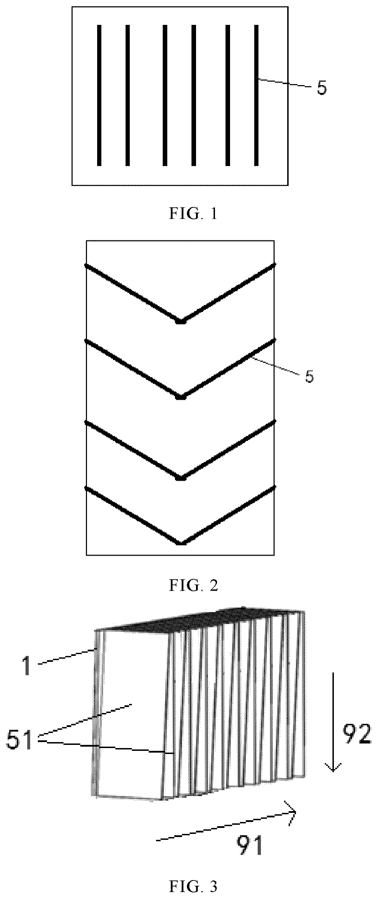

In some related arts, referring to FIG. 1, a heat sink may adopt a "straight-tooth" structure. That is, the heat sink includes a plurality of straight radiating fins 5 (radiating teeth) that extend along the direction of gravity and are arranged at intervals in the horizontal direction. Gas passages are formed between the adjacent radiating fins 5. However, after a surrounding gas (or a surrounding liquid) is heated by the heat emitted from a lower part (with respect to the direction of gravity, the same below) of the heat sink, the hot gas may keep rising. As a result, for different positions on the heat sink, the upper the position, the higher the temperature the poorer the heat dissipation capacity. Therefore, components located in an upper part of a communication device cannot effectively dissipate heat, resulting in the problem of "hot cascade".

In some other related arts, referring to FIG. 2, the heat sink may adopt a "V-shaped-tooth" structure, that is, each radiating fin 5 is in "a V shape", both sides of the V shape extend obliquely upwards, and a plurality of radiating fins 5 are arranged at intervals along the direction of gravity; thus, instead of keeping rising, the hot gas is introduced out from the "obliquely upward" sides, so that the hot cascade may be relieved to some extent. However, since the hot gas mainly flows towards the sides to flow out, when the communication device has a relatively large width (for example, the communication device has a relatively large width-to-height ratio), temperatures at both sides of the heat sink are still too high; meanwhile, except for the lowest radiating fin 5, each radiating fin 5 is blocked by another radiating fin 5 from below. As a result, a low-temperature gas may merely enter between the radiating fins 5 from an outer side of the heat sink (a side of the radiating fins 5 away from the communication device), and particularly when the communication device is installed in a flag-like manner, the inflow of the gas may be blocked by other communication devices, and heat dissipation effect will be reduced according. Thus, even with a heat sink that adopts the V-shaped teeth, the heat dissipation effect remains unsatisfactory in many cases, and the problem of hot cascade persists.

In the first aspect, referring to FIGS. 3 to 14, the embodiments of the present disclosure provide a heat sink.

The heat sink according to the embodiments of the present disclosure includes a heat conducting substrate 1 and a radiating fin group 4 connected to one side of the heat conducting substrate 1; the radiating fin group 4 includes a plurality of main radiating fins 51 arranged at intervals along a first direction 91, each main radiating fin 51 is inclined with respect to a second direction 92, and inclination directions of any two adjacent main radiating fins 51 with respect to the second direction 92 are opposite; and the first direction 91 and the second direction 92 are perpendicular to each other.

Referring to FIG. 3, the heat sink according to the embodiments of the present disclosure is provided with the heat conducting substrate 1 serving as a bearing base, one side of the heat conducting substrate 1 is connected to the radiating fin group 4. That is, radiating fins (the main radiating fins 51 and auxiliary radiating fins 52) in the radiating fin group 4 protrude from the side of the heat conducting substrate 1, and both the heat conducting substrate 1 and the radiating fin group 4 are made of metal and other materials with good heat conductivity.

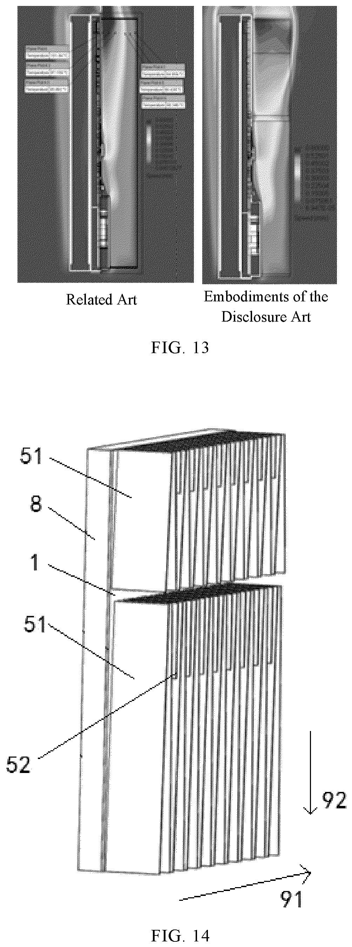

Referring to FIG. 14, the heat sink according to the embodiments of the present disclosure may be assembled with an electronic device 8 (e.g., a communication device) to form an electronic device assembly. A back side (a side away from the radiating fin group 4) of the heat conducting substrate 1 is in contact with the electronic device 8, so that the heat generated by the electronic device 8 may be conducted to the heat conducting substrate 1 and then to the radiating fin group 4, and finally dissipated from the radiating fin group 4 to a gas (or a liquid), thereby achieving heat dissipation.

The radiating fin group 4 and the heat conducting substrate 1 of the heat sink may be an integral structure, which is formed, for example, by means of integrated die casting or machining and forming. Alternatively, the radiating fin group 4 and the heat conducting substrate 1 may be separately manufactured and then connected together. For example, the radiating fins (the main radiating fins 51 and the auxiliary radiating fins 52) may be connected to the heat conducting substrate 1 by means of embedding, press riveting, welding (such as laser welding) or bonding.

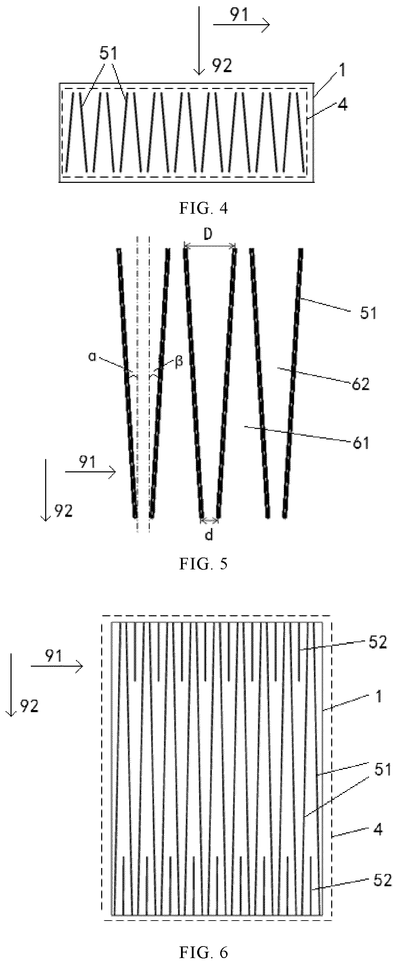

Referring to FIG. 4, each radiating fin group 4 includes the plurality of main radiating fins 51 arranged at intervals along the preset first direction 91. The overall extension direction of each main radiating fin 51 is inclined with respect to the preset second direction 92 (that is, an included angle between the overall extension direction and the second direction 92 is greater than 0 degree and less than 90 degrees). Referring to FIG. 5, the inclination directions of two adjacent main radiating fins 51 (which are adjacent to each other along the first direction 91) with respect to the second direction 92 are opposite, so that the adjacent main radiating fins 51 alternately form "a shape of a Chinese character " 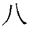 "-a shape of an inverted Chinese character " 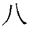 "-a shape of a Chinese character " 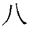 "-a shape of an inverted Chinese character " 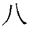 "..." along the first direction 91.

Referring to FIG. 14, when the electronic device 8 is in normal use (arranged in a predetermined arrangement manner), the heat sink is also arranged in a certain arrangement manner (orientation), in which case the second direction 92 is the direction of gravity, and the first direction 91 is the horizontal direction.

A specific form of each radiating fin (each main radiating fin 51 or each auxiliary radiating fin 52) may be a straight tooth (that is, each main radiating fin 51 is a flat plate) or other bent structures such as a corrugated tooth and an arc tooth. However, regardless of the specific shape of the main radiating fin 51, a relationship between the overall extension direction of the main radiating fin 51 and the second direction 92 needs to meet the above requirement.

Referring to FIG. 5, a passage (a gas passage) with a gradually changing width is formed between any two main radiating fins 51 adjacent to each other along the second direction 92, and widths of adjacent passages changes along opposite directions; and the passages having the widths that gradually increase along the second direction 92 are referred to as first-type passages 61 (i.e., the passages which have "narrow tops and wide bottoms" and correspond the shapes of the Chinese character " 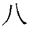 "). Conversely, the passages having the widths that gradually decrease along the second direction 92 are referred to as second-type passages 62 (i.e., the passages which have "wide tops and narrow bottoms" that correspond to the shape of the inverted Chinese character " 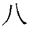 ").

In the heat sink according to the embodiments of the present disclosure, the main radiating fins 51 are inclined with respect to the direction of gravity (i.e., the second direction 92), and the inclination directions of the adjacent main radiating fins 51 are opposite. This arrangement forms the passages with the gradually changing widths between the adjacent main radiating fins 51. When the heat sink is in use, the gas in the first-type passages 61 with "narrow tops and wide bottoms" can be automatically accelerated due to the narrowing of the flow passages while being heated to rise. As a result, for different positions at the heat sink, the upper the position, the faster the gas flows and the better the heat dissipation capacity. Thus, the heat sink according to the embodiments of the present disclosure can produce a good heat dissipation effect and eliminate the problem of hot cascade, or it can realize light weight and miniaturization while maintaining the same heat dissipation effect.

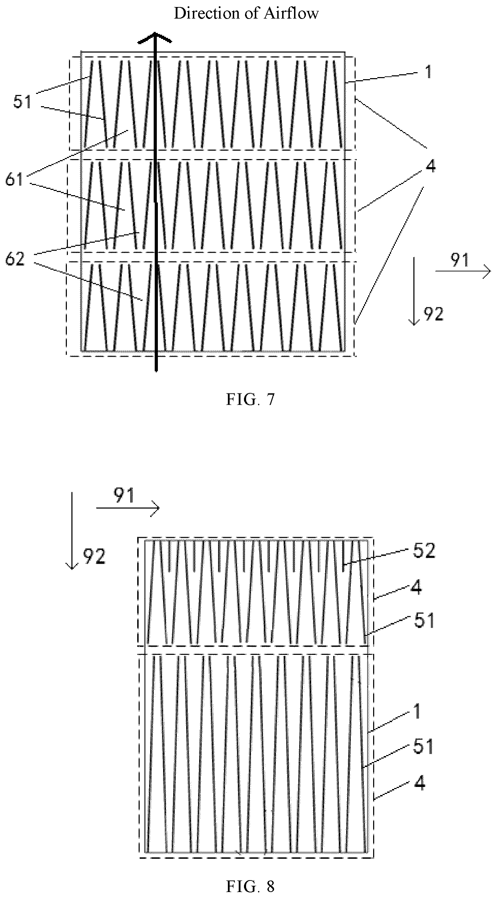

Meanwhile, in the heat sink according to the embodiments of the present disclosure, the gas mainly flows in from a bottom of the heat sink and then flows out from a top of the heat sink (see the airflow direction arrow in FIG. 7), so that the heat dissipation effect of the heat sink is not affected when the electronic device 8 has the large width or adopts the flag manner, and thus is applicable to various situations.

In addition, in the heat sink according to the embodiments of the present disclosure, the second-type passages 62 with ""wide tops and narrow bottoms" can also produce an auxiliary heat dissipation effect.

In some embodiments, the heat conducting substrate 1 is a heat conducting plate; the first direction 91 and the second direction 92 are both parallel to the heat conducting plate; the main radiating fins 51 are perpendicular to the heat conducting plate; and in each radiating fin group 4, all the included angles between the main radiating fins 51 and the second direction 92 are the same, sizes of all the main radiating fins 51 in the second direction 92 are the same, and a minimum distance between any two adjacent main radiating fins 51 in the first direction 91 is the same.

Referring to FIG. 3, in an implementation of the embodiments of the present disclosure, the heat conducting substrate 1 may be a flat plate (i.e., the heat conducting plate), two main surfaces of the heat conducting plate are connected to the radiating fin group 4 and the electronic device 8 respectively, both the first direction 91 and the second direction 92 may be parallel to the heat conducting plate, and each main radiating fin 51 is perpendicular to the heat conducting plate.

Further, referring to FIG. 5, the main radiating fins 51 in the radiating fin group 4 may be uniformly distributed: all the included angles (α, β) between the main radiating fins 51 in the radiating fin group 4 and the second direction 92 are the same. That is, the angles α and β in FIG. 5 have the same values (but have opposite directions), the sizes of all the main radiating fins 51 in the second direction 92 are the same (that is, all the main radiating fins have the same heights and are aligned with each other), and the minimum distance (D) between any two adjacent main radiating fins 51 in the first direction 91 is the same (correspondingly, since all the main radiating fins 51 have the same included angles with respect to the second direction 92 and have the same heights in the second direction 92, a maximum distance D between any two adjacent main radiating fins 51 in the first direction 91 is also the same).

It should be understood that it is also feasible that the sizes of the different main radiating fins 51 in a same radiating fin group 4, the distances between the different main radiating fins 51, and the included angles between the different main radiating fins 51 and the second direction 92 are different (for example, fine-tuned according to heat dissipation requirements).

For example, the sizes (the heights, i.e., a height of the radiating fin group 4) of the main radiating fins 51 in each radiating fin group 4 in the second direction 92 may be determined according to distribution of heat generating devices at a corresponding position in the electronic device 8 to which the heat sink is applicable. For example, the sizes of the main radiating fins 51 in each radiating fin group 4 in the second direction 92 may approximate to a size of a corresponding main heat generating device in the electronic device 8 in the second direction 92.

The number of the main radiating fins 51 in each radiating fin group 4 may be set according to a heat generation amount of corresponding positions of the electronic device 8: on the one hand, the number of the main radiating fins 51 needs to satisfy heat dissipation requirements, so that the minimum number of the main radiating fins 51 may be determined; and on the other hand, the number of the main radiating fins 51 may not be too large, otherwise difficulty of manufacturing process may be increased, cost and weight may be increased, the distances (the distances in the first direction 91) between the main radiating fins 51 may be too small, and the passages may be too narrow to allow the gas to flow smoothly.

For example, the distances between the adjacent main radiating fins 51 may be determined according to a specific size of the electronic device, for example, for an AAU or an RRU with a size typically in the order of hundreds of millimeters, in each radiating fin group 4, the minimum distance (D) between any two adjacent main radiating fins 51 in the first direction 91 needs to be greater than or equal to 5 millimeters, and an average ((D+d)/2) of the minimum distance and the maximum distance (D) needs to be greater than or equal to 12 millimeters.

After the heights and the minimum number of the main radiating fins 51 in each radiating fin group 4 and the minimum value of the distances between the main radiating fins 51 are determined, specific positions and inclination angles (α, β) of the main radiating fins 51 may be set accordingly.

In some embodiments, the radiating fin group 4 further includes the auxiliary radiating fins 52; and the auxiliary radiating fins 52 are located between ends of the adjacent main radiating fins 51 which are away from each other.

Referring to FIG. 6, the radiating fin group 4 may further include the auxiliary radiating fins 52 located between the adjacent main radiating fins 51, so as to enhance heat conduction, narrow the passages, and increase airflow disturbance and airflow velocity, thereby enhancing the heat dissipation effect. In order to avoid narrowing originally narrow positions in the passages by the auxiliary radiating fins 52, referring to FIG. 6, the auxiliary radiating fins 52 are located at the ends of the adjacent main radiating fins 51 which are away from each other, i.e.,, at "wide portions" of the passages.

Referring to FIG. 6, the ends of different adjacent main radiating fins 51 in a single radiating fin group 4 which are away from each other are located at different positions in the second direction 92 (that is, the ends are respectively located at the top and at the bottom). As a result, the auxiliary radiating fins 52 may also be respectively disposed at two ends of the radiating fin group 4 along the second direction 92, and the auxiliary radiating fins 52 at the two ends are located between different adjacent main radiating fins 51.

The auxiliary radiating fins 52 may be specifically arranged in various ways.

For example, referring to FIG. 6, the auxiliary radiating fins 52 are disposed between all the ends of the adjacent main radiating fins 51 which are away from each other; alternatively, referring to the upper radiating fin group 4 in FIG. 8, the auxiliary radiating fins 52 are merely disposed between part of the ends of the adjacent main radiating fins 51 which are away from each other (for example, the auxiliary radiating fins 52 are all located at one end of the radiating fin group 4 along the second direction 92).

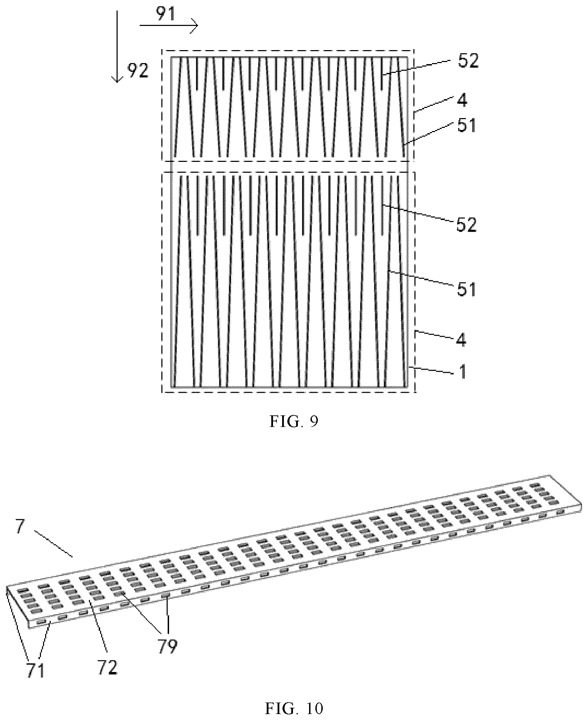

For example, when a plurality of radiating fin groups 4 are provided, referring to FIG. 8, merely part of the radiating fin groups 4 are provided with the auxiliary radiating fins 52; alternatively, referring to FIG. 9, each radiating fin group 4 includes the auxiliary radiating fins 52.

For example, referring to FIG. 6, all the auxiliary radiating fins 52 have the same structures; alternatively, referring to FIG. 9, different auxiliary radiating fins 52 (e.g., the auxiliary radiating fins 52 in different radiating fin groups 4) have different structures.

In some embodiments, in each radiating fin group 4, sizes of the auxiliary radiating fins 52 in the second direction 92 are smaller than or equal to one third of the sizes of the main radiating fins 51 in the second direction 92.

In some embodiments, referring to FIGS. 6, 8 and 9, extension directions of the auxiliary radiating fins 52 are parallel to the second direction 92. That is, all the auxiliary radiating fins 52 extend along the second direction 92. Further, each auxiliary radiating fin 52 is perpendicular to the heat conducting plate.

In an implementation of the embodiments of the present disclosure, the sizes (heights) of the auxiliary radiating fins 52 in the second direction 92 are not desired to be too large. Otherwise the effect of enhancing heat dissipation is limited, the inflow of the gas is blocked, and manufacturing process becomes more difficult and costly. Therefore, referring to FIG. 6, the height of each auxiliary radiating fin 52 does not exceed 1/3 of the height of the main radiating fin 51 of the same radiating fin group.

In some embodiments, the number of radiating fin groups 4 is more than one, and a plurality of radiating fin groups 4 are arranged at intervals along the second direction 92.

As can be seen, an overall height of the heat sink needs to be matched with the corresponding electronic device 8. As a result, when the height of the electronic device 8 is very large, the heights of the main radiating fins 51 are inevitably very large if merely one radiating fin group 4 is provided. Due to the large heights of the main radiating fins 51, the inclination angles of the main radiating fins 51 may be too small, the maximum distance between the adjacent main radiating fins 51 may be too large, or the minimum distance between the adjacent main radiating fins 51 may be too small, such that the main radiating fins 51 cannot play a good role in accelerating the airflow.

In view of this, in an implementation of the embodiments of the present disclosure, referring to FIGS. 7 to 9, the heat sink may be provided with a plurality of radiating fin groups 4 arranged at intervals along the second direction 92 (the direction of gravity), that is, a plurality of groups of "discontinuous" main radiating fins 51 are provided along the second direction 92.

The radiating fin groups 4 may be arranged according to the positions of the heat generating devices in the corresponding electronic device 8.

For example, if the heat generating devices in the electronic device 8 are mainly distributed in two parts spaced apart in the second direction 92, each radiating fin group 4 may be arranged for the position of each of the two parts. Thus, on the one hand, effective heat dissipation can be achieved for all the heat generating devices, and on the other hand, the main radiating fins 51 for the different heat generating devices may be separated, so as to prevent the heat generating devices with lower temperatures from being heated by the heat generating devices with higher temperatures.

Referring to FIG. 7, different radiating fin groups 4 have the same structures (such as the heights and the inclination angles of the main radiating fins 51, the distances between the main radiating fins 51, and whether the auxiliary radiating fins 52 are provided); alternatively, referring to FIGS. 8 and 9, different radiating fin groups 4 have different structures.

In some embodiments, for any two adjacent radiating fin groups 4, the ends of any two adjacent main radiating fins 51 in one radiating fin group 4 which are close to each other are opposite to (aligned with) the ends of two adjacent main radiating fins 51 in the other radiating fin group 4 which are away from each other.

In an implementation of the embodiments of the present disclosure, referring to FIG. 7, for two adjacent radiating fin groups 4 (which are adjacent to each other along the second direction 92), the ends of the main radiating fins 51 in one radiating fin group 4 which are close to each other correspond to the ends of the main radiating fins 51 in the other radiating fin group 4 which are away from each other. In other words, for the adjacent radiating fin groups 4, the first-type passages 61 in one radiating fin group 4 are communicated with the first-type passages 61 in the other radiating fin group 4, and the second-type passages 62 in one radiating fin group 4 are communicated with the second-type passages 62 in the other radiating fin group 4.

Thus, referring to FIG. 7, the gas rising out of the first-type passages 61 in a lower radiating fin group 4 inevitably enters lower ends of the first-type passages 61 of an upper radiating fin group 4, and is accelerated again in the upper first-type passages 61, so that an overall airflow direction is from bottom to top (as shown by the arrow in FIG. 7), which can further enhance the airflow at an upper part of the heat sink and improve heat exchange efficiency.

In some embodiments, the included angles between the main radiating fins 51 in the first radiating fin group 4 along the second direction 92 and the second direction 92 are greater than or equal to the included angles between the main radiating fins 51 in the other radiating fin groups 4 and the second direction 92.

As described above, the inclination angles of the main radiating fins 51 in each radiating fin group 4 with respect to the second direction 92 may be the same or different. Referring to FIG. 8, it may be ensured that the inclination angles (α, β) of the main radiating fins 51 in the "uppermost" radiating fin group 4 are the largest. That is, the inclination angles of the main radiating fins 51 in the uppermost radiating fin group 4 may be larger than those of the main radiating fins 51 in the other radiating fin groups 4, or may be the same as those of the main radiating fins 51 in the other radiating fin groups 4, but may not be smaller than those of the main radiating fins 51 in the other radiating fin groups 4.

It should be understood that, in the case where the inclination angles of different main radiating fins 51 in one radiating fin group 4 are different, it needs to be ensured that the minimum inclination angle of the main radiating fins 51 in the uppermost radiating fin group 4 and the maximum inclination angle of the main radiating fins 51 in the other radiating fin groups 4 still satisfy the above relationship.

It should be understood that, in the case where the inclination angles of the main radiating fins 51 in the uppermost radiating fin group 4 are the largest, if there are a plurality of other radiating fin groups 4, the inclination angles of the main radiating fins 51 in the plurality of other radiating fin groups 4 may be the same or different.

Since the inclination angles of the main radiating fins 51 in the uppermost radiating fin group 4 are the largest, the airflow velocity can be sufficiently increased, and it can be ensured that the gas finally flows out smoothly. Meanwhile, since the inclination angles of the main radiating fins 51 in the lower radiating fin groups 4 are not too large, it can be ensured that the gas flows in smoothly.

In some embodiments, referring to FIGS. 10 to 12, the heat sink according to the embodiments of the present disclosure further includes at least one cover plate 7; the cover plate 7 includes two oppositely arranged clamping plates 71 and an outer plate 72 connected between the two clamping plates 71, the two clamping plates 71 are located on the same side of the outer plate 72, and both the clamping plates 71 and the outer plate 72 are provided with a plurality of heat dissipation ports 79; the heat conducting substrate 1 and/or the main radiating fins 51 (and optionally the auxiliary radiating fins 52) are provided with a plurality of slots 75 that are arranged at intervals along the second direction 92 and extend along the first direction 91; and the two clamping plates 71 of each cover plate 7 are fit in two slots 75 respectively, and the outer plate 72 is in contact with one sides of the main radiating fins 51 located between the two slots 75 and away from the heat conducting substrate 1.

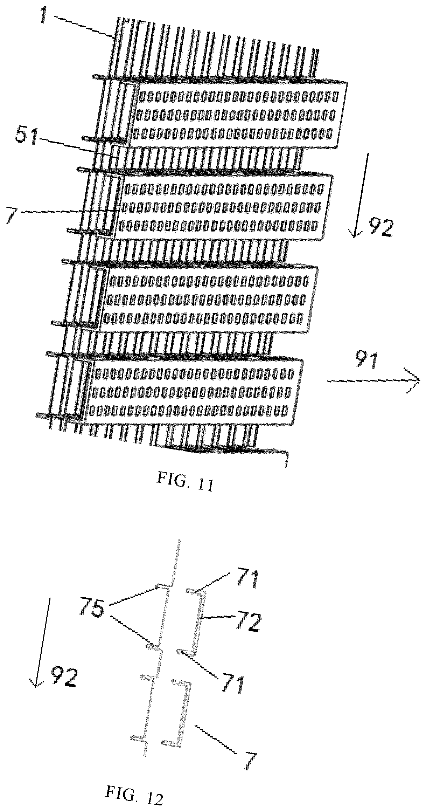

In an implementation of the embodiments of the present disclosure, referring to FIG. 11, the cover plate 7 may be disposed on an outer side of the heat sink (the sides of the main radiating fins 51 away from the heat conducting substrate 1) to increase heat dissipation area, and a "chimney" effect may be produced between the cover plate 7 and the main radiating fins 51 to enhance convective heat transfer, thereby further improving the heat dissipation effect.

A large number of heat dissipation ports 79 need to be provided at each position of the cover plate 7 to allow the gas to pass through.

Referring to FIG. 10, the cover plate 7 may include the two clamping plates 71 connected by the outer plate 72, forming a structure that resembles the shape of "n" when viewed from the side, as shown in FIG. 12. The heat conducting substrate 1 and/or the main radiating fins 51 are provided with the slots 75 for fitting and fastening with the clamping plates 71 of the cover plate 7. Thus, referring to FIG. 11, the cover plate 7 may be disposed "over" the main radiating fins 51 (and optionally the auxiliary radiating fins 52) in a snap-in manner from the outer sides of the main radiating fins 51.

If the slots 75 are disposed in the heat conducting substrate 1 (e.g., grooves on a surface of the heat conducting substrate 1), the clamping plates 71 are correspondingly located at the top or the bottom of the radiating fin group 4; and if the slots 75 are disposed in the main heat dissipating fins 51 (e.g., gaps in the main heat dissipating fins 51), the clamping plates 71 are correspondingly fit in one radiating fin group 4.

Compared with a method of connecting the cover plate by riveting in the related art, the cover plate 7 according to the embodiments of the present disclosure does not have the problem of non-uniform positions and directions of rivet points, and has small difficulty of manufacturing process, close contact between the cover plate 7 and the main radiating fins 51 (and optionally the auxiliary radiating fins 52) can be ensured, and a good heat transfer effect can be provideds.

In some embodiments, in each radiating fin group 4, the first-type passage 61 or the second-type passage 62 is formed between any two adjacent main radiating fins 51; along the second direction 92 (the "downward" direction of gravity), the width of the first-type passage 61 gradually increases, and the width of the second-type passage 62 gradually decreases; and the heat dissipation ports 79 in the clamping plates 71 are located at positions corresponding to the first-type passages 61.

As can be seen, the clamping plates 71 may block the passages between the adjacent main radiating fins 51 at the positions with no heat dissipation ports. As described above, the heat dissipation is mainly realized through the first-type passages 61 with the narrow tops and the wide bottoms in the radiating fin group 4, so that the heat dissipation ports 79 in the clamping plates 71 need to correspond to all the first-type passages 61 at least, so as to at least ensure the smooth flow of the gas in the first-type passages 61.

Referring to FIG. 13, an airflow velocity cloud map of different positions of the heat sink adopting the straight teeth in a height direction in the related art and an airflow velocity cloud map of different positions of the heat sink according to the embodiments of the present disclosure in a height direction are respectively obtained by simulation calculation.

As can be seen from FIG. 13, the heat sink according to the embodiments of the present disclosure can effectively accelerate the airflow, especially the airflow over the heat sink, thereby greatly improving the heat dissipation effect (a temperature of the upper part of the heat sink can be lowered by about 2°C).

In a second aspect, referring to FIGS. 3 to 14, the embodiments of the present disclosure provide an electronic device assembly, including the electronic device 8 and the heat sink according to any one of the embodiments of the present disclosure; a heat conduction passage is formed between the electronic device and a side of the heat conducting substrate 1 away from the radiating fin group 4; and the second direction 92 is the direction of gravity when the electronic device 8 is arranged in a predetermined arrangement manner.

Referring to FIG. 14, the electronic device assembly according to the embodiments of the present disclosure includes the electronic device 8 that requires heat dissipation, and the heat conduction passage is formed between the electronic device 8 and the back side of the heat conducting substrate 1 of the heat sink, enabling effective heat dissipation through the heat sink.

When in normal use, the electronic device 8 needs to be arranged in a determined "predetermined arrangement manner". When the electronic device 8 adopts the predetermined arrangement manner, the second direction 92 of the heat sink is also determined, that is, the second direction 92 of the heat sink is the direction of gravity (that is, parallel to the direction of gravity and having the same orientation).

The electronic device 8 may be a communication device, such as an AAU or an RRU. It should be understood that the electronic device 8 may be any other devices that generate heat during operation and have a need for heat dissipation.

The heat conduction passage between the electronic device 8 and the heat conducting substrate 1 may be formed with various methods. For example, a housing of the electronic device 8 and the back side of the heat conducting substrate 1 may be in direct contact, or may be connected with a thermally conductive adhesive, or may be welded together, or may be made into an integral structure, which will not be described in detail herein.

The arrangement manner of the electronic device 8 may be a flag manner, a pole-holding manner, a wall hanging manner, or a flat manner, which will not be described in detail herein.

The present disclosure discloses the exemplary embodiments using specific terms, but the terms are merely used and should be merely interpreted as having general illustrative meanings, rather than for the purpose of limitation. Unless expressly stated, it is apparent to those of ordinary skill in the art that features, characteristics and/or elements described in connection with a particular embodiment can be used alone or in combination with features, characteristics and/or elements described in connection with other embodiments. Therefore, it should be understood by those of ordinary skill in the art that various changes in the forms and the details can be made without departing from the scope of the present disclosure of the appended claims.

## Claims

1. A heat sink, comprising a heat conducting substrate and a radiating fin group connected to a side of the heat conducting substrate,
wherein the radiating fin group comprises a plurality of main radiating fins arranged at intervals along a first direction, one of main radiating fins is inclined with respect to a second direction, and inclination directions of any two adjacent main radiating fins with respect to the second direction are opposite; and the first direction and the second direction are perpendicular to each other.

2. The heat sink of claim 1, wherein
the heat conducting substrate is a heat conducting plate;
the first direction and the second direction are both parallel to the heat conducting plate;
the main radiating fins are perpendicular to the heat conducting plate; and
a number of the radiating fin group is at least one, and in each radiating fin group, the main radiating fins have the same included angles with respect to the second direction, the same sizes in the second direction, and the same minimum distance between any two adjacent main radiating fins in the first direction.

3. The heat sink of claim 1, wherein
the radiating fin group further comprises auxiliary radiating fins; and
the auxiliary radiating fins are located between ends of adjacent main radiating fins which are away from each other.

4. The heat sink of claim 3, wherein
in each radiating fin group, sizes of the auxiliary radiating fins in the second direction are smaller than or equal to one third of sizes of the main radiating fins in the second direction.

5. The heat sink of claim 1, wherein
a number of radiating fin groups is more than one, and a plurality of radiating fin groups are arranged at intervals along the second direction.

6. The heat sink of claim 5, wherein
for any two adjacent radiating fin groups, ends of any two adjacent main radiating fins in one radiating fin group which are close to each other are opposite to ends of two adjacent main radiating fins in another radiating fin group which are away from each other.

7. The heat sink of claim 5, wherein
included angles between the main radiating fins in a first radiating fin group along the second direction and the second direction are greater than or equal to included angles between the main radiating fins in other radiating fin groups and the second direction.

8. The heat sink of claim 1, further comprising at least one cover plate,
wherein the at least one cover plate comprises two oppositely arranged clamping plates and an outer plate connected between the two clamping plates, the two clamping plates are located on a same side of the outer plate, and both the clamping plates and the outer plate are provided with a plurality of heat dissipation ports;
the heat conducting substrate and/or the main radiating fins are provided with a plurality of slots that are arranged at intervals along the second direction and extend along the first direction; and
the two clamping plates of the at least one cover plate are fit in two slots respectively, and the outer plate is in contact with sides of the main radiating fins located between the two slots and away from the heat conducting substrate.

9. The heat sink of claim 8, wherein
in each radiating fin group, a first-type passage or a second-type passage is formed between any two adjacent main radiating fins; along the second direction, a width of the first-type passage gradually increases and a width of the second-type passage gradually decreases; and
the heat dissipation ports in the clamping plates are located at positions corresponding to the first-type passage.

10. An electronic device assembly, comprising an electronic device and the heat sink of any one of claims 1 to 9,
wherein a heat conduction passage is formed between the electronic device and a side of the heat conducting substrate away from the radiating fin group; and
the second direction is the direction of gravity in the case where the electronic device is arranged in a predetermined arrangement manner.
